# EUROPEAN PATENT SPECIFICATION

(11) **EP 0 814 484 B1**
(45) Date of publication and mention of the grant of the patent: **17.09.2003**
(21) Application number: 96830348.7
(22) Date of filing: 18.06.1996
(51) Int. Cl.: G11C 16/06

(54) **Nonvolatile memory with a single-cell reference signal generating circuit for reading memory cells**
Nichtflüchtiger Speicher mit Einzelzellenreferenzsignalgeneratorschaltung zum Auslesen von Speicherzellen
Mémoire non-volatile avec circuit de génération de signal de référence à cellule unique pour la lecture de cellules à mémoire

(43) Date of publication of application: 29.12.1997
(73) Proprietor: STMicroelectronics S.r.l., 20041 Agrate Brianza (Milano) (IT)
(72) Inventor: Campardo, Giovanni, 24128 Bergamo (IT); Micheloni, Rino, 22078 Turate (IT); Commodaro, Stefano, 16031 Bogliasco (IT)
(74) Representative: Cerbaro, Elena, Dr.

(56) References cited:
- WO-A-90/12400
- US-A- 4 393 475
- US-A- 5 289 412

## Description

The present invention relates to a nonvolatile memory with a single-cell reference signal generating circuit for reading memory cells.

As is known, to read the cells of nonvolatile, particularly flash, memories, the row and column to which the cell to be read is connected are appropriately biased and the current flowing through the cell is detected. If the cell is written, its threshold voltage is higher than the read voltage and the cell conducts no current; if the cell is erased, its threshold voltage is lower than the read voltage, and the cell conducts current; and written and erased cells are discriminated by comparing the current flowing in the cell with a reference current generated by a reference cell.

As such, reading accuracy depends largely on efficient operation of the reference cells and, more specifically, on the characteristics of the cells being as similar as possible to those of the array cells (i.e. no spread of the electric characteristics of the reference cells is desired).

Since the need, however, to minimize spread clashes with other design requirements, two different approaches are adopted in the design of reference cells: a first in which the data cells and respective reference cells with which they are compared are located as close as possible to one another; and a second in which the reference cells are located outside the memory array.

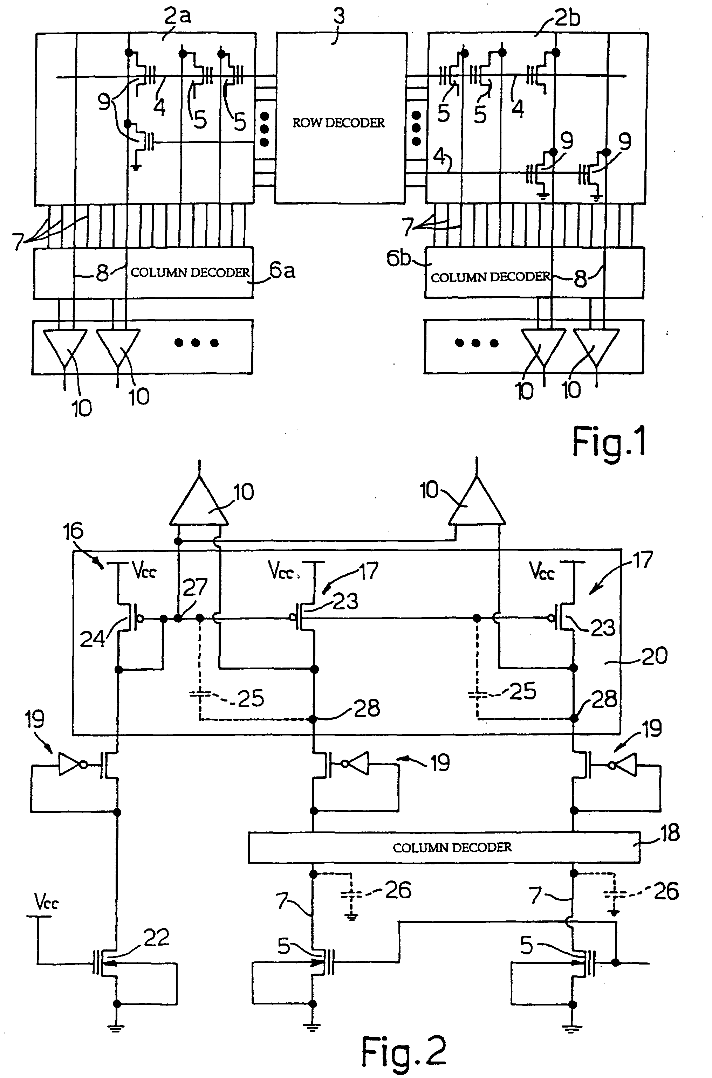

The first approach (reference cells close to the data cells) is used, for example, in EPROM memories, in which a column of the array, one for each output bit, is used as a reference. Such a solution is shown by way of example in Figure 1, in which the memory array is divided into two subarrays 2a, 2b connected to a row decoder 3 for addressing the word lines 4 (one for each row in the array) connected to the gate terminals of data cells 5 and reference cells 9. The drain terminals of data cells 5 are connected to respective bit lines 7 (one for each column in the array not used as a reference) which are connected by two column decoders 6a, 6b to a plurality of sense amplifiers 10. More specifically, each sense amplifier 10 presents a first input connected each time to one bit line 7 addressed by column decoder 6a, 6b; and a second input connected to a respective reference line 8 to which the reference cells 9 in the same reference column are connected.

This first approach presents several advantages: in particular, spread is minimized by each data cell being located close to the respective reference cell; the reference cell is turned on together with the data cell to be read, seeing as both are connected to the same word line (thus eliminating any timing problems); and the load transistors in the data and reference branches (not shown and connected to the inputs of the sense amplifiers) are the same. On the other hand, it also presents disadvantages: the reference cells are subjected to stress by undergoing the same operations as the data cells; and it is particularly bulky in that one column of the array for each output bit cannot be used for storing data.

When applied to flash memories, further disadvantages are encountered: first of all, the ground of the reference columns must be separate from the rest of the sector to which they belong, otherwise their cells would become deplete when erasing via the source terminal; the stress to which the reference columns are subjected may lead to cycling problems (multiple erase and write cycle operation); and, finally, in the event of other than the desired UV threshold being obtained during fabrication, there is little feasibility of matching the threshold voltages of individual reference cells, e.g. of correcting the threshold voltages of all the cells in the same column.

The second approach (reference cells outside the memory array) provides for writing and erasing the reference cells during testing so as to obtain the best possible reference. On the other hand, the characteristic spread of the reference cells assumes greater importance on account of the physical distance between the reference and respective data cells and between the reference cells themselves. One solution to the problem is to use a single reference cell, e.g. a single reference branch connected to all the sense amplifiers as shown in Figure 2, which shows two sense amplifiers 10 with a first input connected to a common reference branch 16, and a second input connected to a respective array branch 17; a column decoder 18 interposed between each bit line 7 and a respective biasing circuit 19; and a current/voltage converter 20 for converting the current flowing in data cells 5 and in the single reference cell 22, and comprising a PMOS load transistor 23 for each array branch, and a diode-connected PMOS load transistor 24 for common reference branch 16.

In the Figure 2 circuit, capacitors 25 represent the parasitic capacitances between the gate and drain terminals of load transistors 23 (nodes 27, 28); capacitors 26 represent the capacitances of the other bit lines (not shown) connected to the same array branches 17 via column decoder 18; and capacitors 25, 26 form capacitive couplings between the array branches and the reference branch, so that, when the outputs of sense amplifiers 10 switch, the voltage shift of array branches 18 of each sense amplifier 10 may result in read problems by disturbing common reference branch 16.

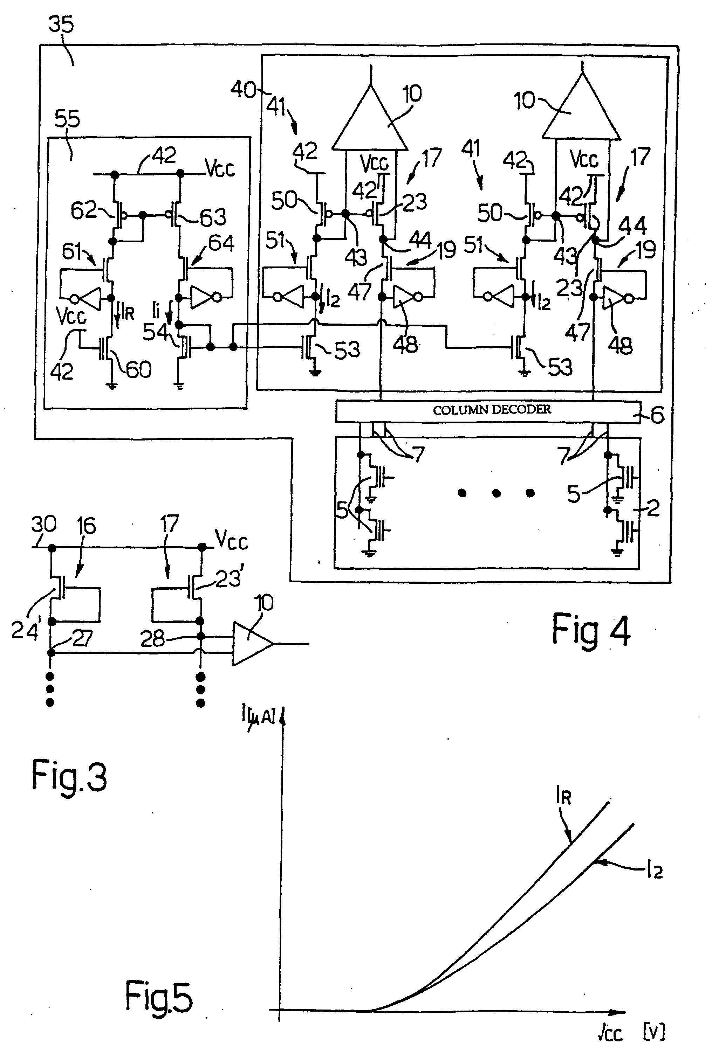

The above drawback may be overcome by modifying current/voltage converter 20 as shown in Figure 3, in which the load transistors 23' of array branch 17 and 24' of common reference branch 16 are all diode-connected and no longer have the gate terminals connected to one another. Such a solution, however, impairs the dynamic performance of the circuit, on account of nodes 28 of array branches 17 at most reaching a voltage of V_{CC} - V_{TH}, where V_{CC} is the supply voltage along line 30 to which the source terminals of transistors 23' and 24' are connected, and V_{TH} is the threshold voltage of transistors 23' (minimum voltage drop between the source and gate terminals of transistors 23' for them to be turned on). A reduction in dynamic performance, on the other hand, is to be avoided, and is by no means negligible when the circuit operates at low supply voltage.

US-A-5,289,412 describes a nonvolatile memory according to the preamble of claim 1. In this document, the problem is met of compensating the differences in the biasing voltages of the transistors of the connection portion, that are current-mirror connected, which differences may lead to the reference currents lead to the sense amplifiers to differ from the current generated by the reference cell. To this end, biasing elements are suitably inserted, to cause the current-mirror connected transistors to operate in the same way, despite of variations in voltages, temperature and other factors.

This document does not however face the problem of compensating the error due to the fact that the current generating element (reference cell) and the components of the connection portion, that are MOS transistors, are different.

It is an object of the present invention to provide a memory featuring a reference signal generating circuit designed to overcome the aforementioned drawbacks.

According to the present invention, there is provided a nonvolatile memory with a single-cell reference signal generating circuit for reading memory cells, as claimed in Claim 1.

A preferred, non-limiting embodiment of the present invention will be described by way of example with reference to the accompanying drawings, in which:
Figure 1 shows a block diagram of a known memory array and relative read circuits;
Figure 2 shows an electric diagram of a known read circuit;
Figure 3 shows a known different embodiment of a detail of the Figure 2 circuit;
Figure 4 shows an electric diagram of a read circuit;
Figure 5 shows a graph of two quantities relative to the Figure 4 diagram;
Figure 6 shows an electric diagram of an embodiment of the present invention.

In Figure 4, any elements common to the Figure 2 circuit are shown using the same numbering system, and of the nonvolatile memory, indicated by 35, only the parts necessary to the comprehension are shown, including a read circuit 40, a column decoder 6, a memory array 2, and a reference signal generating circuit 55.

Read circuit 40 comprises a plurality of sense amplifiers 10 (only two shown), each presenting a first input connected to a respective array branch 17, and a second input connected to a respective reference branch 41; each array branch 17 comprises a PMOS load transistor 23 with the source terminal connected to a supply line 42 at V_{CC}, the gate terminal connected to a node 43, and the drain terminal connected to a node 44; in known manner, column decoder 6 connects one of a plurality of bit lines 7 at a time to node 44 via a biasing circuit 19; and each bit line 7 of each array branch 17 is connected to a plurality of data cells 5 forming part of memory array 2. Biasing circuit 19, which provides for preventing spurious (so-called soft) writing of the cells, comprises an NMOS transistor 47 with the drain terminal connected to node 44 and the source terminal connected to column decoder 6; and an inverter 48 with the input connected to the source terminal of transistor 47, and the output connected to the gate terminal of transistor 47 so as to control the power-on level of transistor 47 in known manner and (by negative feedback) maintain the bit line 7 connected each time to array branch 17 at the desired biasing voltage (typically 1 V).

Each reference branch 41 comprises a respective diode-connected PMOS load transistor 50 with the source terminal connected to supply line 42, and the gate and drain terminals connected to each other and to node 43; and a biasing circuit 51 similar to circuit 19 (and therefore not described in detail) interposed between node 43 and the drain terminal of an NMOS native (i.e. low-threshold-voltage) transistor 53 with the source terminal grounded. All the gate terminals of native transistors 53 of array branches 17 are connected to one another and to the gate terminal of a single NMOS native transistor 54 connected to form a current mirror with native transistors 53 and forming part of reference signal generating circuit 55; and native transistors 53 and 54 present the same W/L ratio so as to form a 1:1 current mirror.

Reference signal generating circuit 55 comprises a single flash cell 60 located outside memory array 2 with the gate terminal connected to supply line 42 at V_{CC}, the source terminal grounded, and the drain terminal connected to the drain terminal of a PMOS transistor 62 via a biasing circuit 61 similar to circuits 19; transistor 62 has the source terminal connected to supply line 42, and is diode-connected with the drain and gate terminals connected to each other and to the gate terminal of a PMOS transistor 63 forming a 1:1 current mirror circuit with transistor 62; and transistor 63 has the source terminal connected to supply line 42, and the drain terminal connected to the drain terminal of native transistor 54 via a biasing circuit 64 similar to circuits 19.

In memory 35, the current I_{R} flowing through cell 60 is mirrored by the current mirror circuit formed by transistors 62, 63 to native transistor 54 (current I₁) and by the current mirror circuit formed by native transistors 54, 53 to the various reference branches 41 (currents I₂); biasing circuits 61, 64, 51 provide for biasing the drain terminals of reference cell 60 and transistors 54, 53 at the same voltage as memory cells 5, to ensure native transistors 53 are in the same condition as transistor 54, currents I₂ are actually equal to current I₁ and hence current I_{R} of reference cell 60, and reference branches 41 are in the same condition as array branches 17.

As supply voltage V_{CC} increases, however, currents I_{R} and I₂ tend to diverge on account of the operating conditions of reference cell 60 and transistor 54 (two different components) possibly not being exactly the same, and on account of the drain-source voltage drop V_{DS} of transistor 53 possibly differing from that of transistor 54, due to voltage V_{DS} of transistor 54 being imposed by reference cell 60 via current mirror 62, 63, and voltage V_{DS} of transistor 53 depending on the performance of respective reference branch 41 (and hence read circuit 40). As shown in the Figure 5 plot of currents I_{R} and I₂ versus V_{CC}: as shown, at the beginning both currents increase in the same way, then they diverge slightly, the current in transistor 53 becoming greater than that of cell 60 and so possibly resulting in read errors or uncertainty.

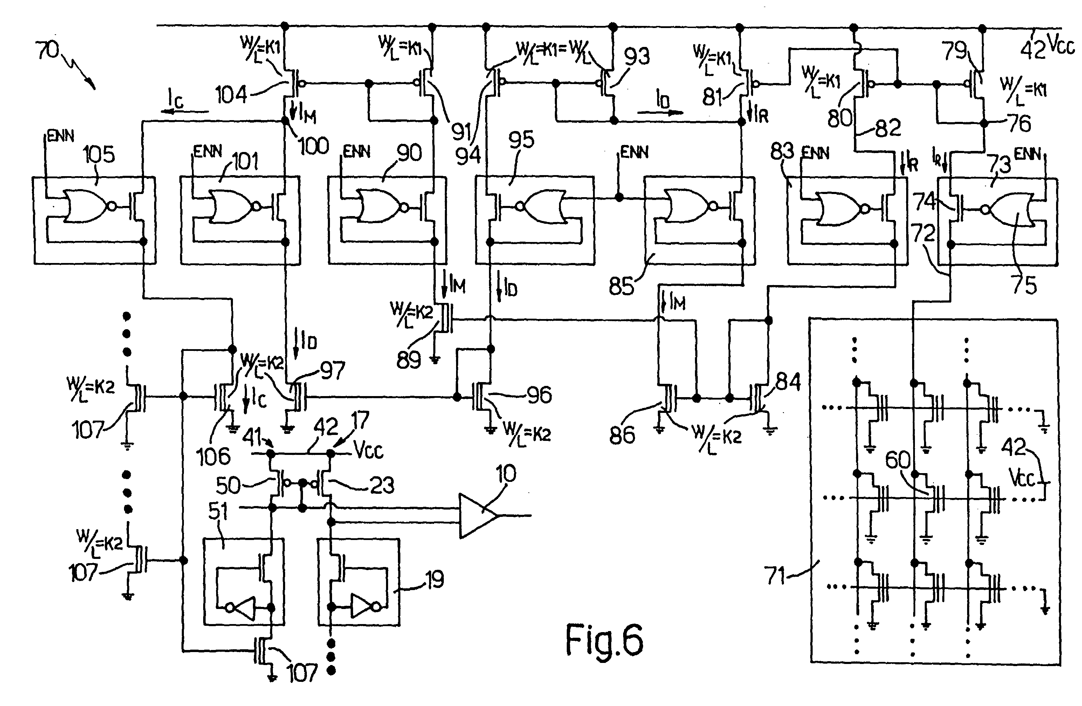

For solving this problem according to the invention, Figure 6 shows an embodiment of the reference signal generating circuit, here indicated 70, which provides for performing a sort of "predictive" equalizing function by generating a current equal to the difference, caused by differing operating conditions and geometry, between the current in reference cell 60 and that of a first MOS transistor connected to the cell by two current mirror circuits,. and by subtracting the difference current from the current flowing in another MOS transistor.

More specifically, in the Figure 6 embodiment, reference cell 60 forms part of a small array 71 of, say, 8x8 cells separated from memory array 2 (not shown), is selected from among the innermost cells of array 71 to reduce the edge effects, and has the gate terminal connected to supply line 42 at V_{CC}, the source terminal grounded, and the drain terminal connected to a line 72 in turn connected to a biasing circuit 73 similar to circuit 19 in Figure 4 but presenting an enabling input. More specifically, biasing circuit 73 comprises an NMOS transistor 74 with the source terminal connected to line 72, the drain terminal defining a node 76, and the gate terminal connected to the output of a NOR gate 75, which has a first input connected to the drain terminal of transistor 74, and a second input receiving an inverted enabling signal ENN. Consequently, when signal ENN is low, NOR gate 75, like circuit 19 described above, maintains line 72 (and hence the drain terminal of reference cell 60) at the desired bias voltage (1 V); and, when high, signal ENN forces the output of NOR gate 75 to low so as to turn off transistor 74, cut off the connection between node 76 and cell 60, and reduce consumption in standby mode.

A diode-connected PMOS load transistor 79 has the source terminal connected to supply line 42, the gate and drain terminals connected to node 76, a dimensional (channel width/length) ratio W/L = K1, and is so connected as to form a current mirror with two PMOS transistors 80, 81 with a width/length ratio W/L = K1. Transistor 80 has the source terminal connected to supply line 42, the gate terminal connected to node 76, and the drain terminal connected to a node 82; and, via a biasing circuit 83 similar to circuit 73 and therefore not described in detail, node 82 is connected to the drain terminal of an NMOS native transistor 84, which is diode-connected (shorted gate and drain terminals) and has the source terminal grounded and a width/length ratio W/L = K2.

Transistor 81 has the source terminal connected to supply line 42, the gate terminal connected to node 76, and the drain terminal (defining a node 92) connected, via a biasing circuit 85 similar to circuit 73, to the drain terminal of an NMOS native transistor 86 with the gate terminal connected to the gate terminal of transistor 84, and the source terminal grounded; native transistor 86 presents the same width/length ratio W/L = K2 as native transistor 84 with which it forms a 1:1 current mirror circuit; and native transistor 84 is connected to form a current mirror circuit with a further NMOS native transistor 89 having a width/length ratio W/L = K2 and the drain terminal connected, via a biasing circuit 90 similar to those above, to the drain terminal of a diode-connected PMOS transistor 91 with the source terminal connected to supply line 42.

Node 92 is also connected to the drain terminal of a diode-connected PMOS transistor 93 with the source terminal connected to supply line 42; transistor 93 presents a width/length ratio W/L = K1, and is connected to form a current mirror circuit with a PMOS transistor 94 having the source terminal connected to supply line 42 and the drain terminal connected, via a biasing circuit 95 similar to those above, to the drain terminal of a diode-connected NMOS native transistor 96; native transistor 96 has the source terminal grounded, the gate terminal connected to the gate terminal of an NMOS native transistor 97, and a width/length ratio W/L = K2; native transistor 97 has the source terminal grounded, the drain terminal connected to a node 100 via a biasing circuit 101 similar to those above, and the same width/length ratio as transistor 96 with which it is connected to form a current mirror circuit; and node 100 is connected to the drain terminal of a PMOS transistor 104 with the source terminal connected to supply line 42, the gate terminal connected to the gate terminal of transistor 91, and the same width/length ratio W/L = K1 as transistor 91 with which it forms a 1:1 current mirror circuit.

Via a biasing circuit 105 similar to those above, node 100 is connected to the drain terminal of an NMOS native transistor 106 similar to transistor 54 in Figure 4 and connected, like transistor 54, to form a current mirror circuit with transistors 107 forming part of the various reference branches 41 of each sense amplifier 10. Native transistor 106 is diode-connected, has the source terminal grounded, the gate terminal connected to its own drain terminal and to the gate terminal of transistors 107, and the same width/length ratio W/L = K2 as transistors 107, which in turn have the source terminal grounded and the drain terminal connected to the respective biasing circuit 51.

The Figure 6 circuit operates as follows.

Transistor 84 is similar to transistor 54 in Figure 4; and transistor 86, connected to form a mirror circuit with transistor 84, is similar to transistors 53 in Figure 4, except that it presents two load transistors (81 and 93) as opposed to one (transistor 50). As such, transistor 86 is flown by a current I_{M} similar to the current in transistors 53 and slightly different from the current I_{R} flowing in cell 60, in load transistor 79 and in transistors 80 and 81 forming a current mirror with transistor 79. Therefore load transistor 93, by which native transistor 86 is supplied with the difference between the current I_{M} drawn by native transistor 86 and the current I_{R} supplied by transistor 81, presents a current I_{D} = I_{M} - I_{R}, which is mirrored to load transistor 94, supplied to transistor 96, and again mirrored to transistor 97. The current I_{M} in transistor 86 is also mirrored to transistor 89 and supplied to mirror-connected transistors 91 and 104; and the compensated current I_{C} supplied by node 100 and drawn by native transistor 106 therefore equals the difference between current I_{M} in transistor 104 and current I_{D} in transistor 97 according to the equation:${\text{I}}_{\text{C}} {\text{= I}}_{\text{M}} {\text{- I}}_{\text{D}} {\text{= I}}_{\text{M}} {\text{- (I}}_{\text{M}} {\text{- I}}_{\text{R}} {\text{) = I}}_{\text{R}}$

Current I_{C} is then supplied to and mirrored by transistor 106 to transistors 107 of the various read circuits. That is to say, transistor 106 presents a different drain-source voltage V_{DS} as compared with transistor 54 in Figure 4 and is therefore capable of supplying the various read circuits with a compensated current I_{C} practically equal to the current I_{R} generated by cell 60.

The above circuit therefore provide for exploiting the advantages of solutions with reference cells outside the memory array, for accurately regulating the threshold voltage and hence current supply for a given supply voltage, and for eliminating capacitive coupling problems and hence the effect of voltage variations in the array branch on the current and voltage values in the reference branch. Moreover, the circuit according to the invention also eliminates the effects due to the less than ideal nature of the circuit, and which are especially sensitive to high supply voltages.

The solution described is simple and easy to integrate with no additional area required. On the contrary, in the case of reference integrated in the memory array, integration area is actually reduced and the layout optimized by the generating circuits being located in appropriate spaces already available on the chip.

Clearly, changes may be made to the memory as described and illustrated herein without, however, departing from the scope of the present invention, as defined in the appended claims.

## Claims

1. A nonvolatile memory (35) comprising a data memory array (2) including memory cells (5); a read circuit (40) comprising a plurality of sense amplifiers (10), each connected to a respective array branch (17) for connection to said memory cells; and a reference generating circuit (70) comprising a reference cell (60) arranged outside said data memory array (2) for generating a reference signal (IR), said reference generating circuit (70) comprising a plurality of reference branches (41), each connected to a respective sense amplifier (10) and including electronic components, and connection means (72-106) interposed between said reference cell (60) and said reference branches (41) for supplying said reference branches with a first operating signal (I2, IC) correlated to said reference signal (IR),
**characterized in that** said connection means comprises generating means (84, 86) connected at the input to said reference cell and generating at the output a second operating signal (IN) correlated to said reference signal (IR) and presenting an error; first subtracting means (81, 92, 93) connected at the input to said reference cell (60) and to said first generating means (84, 86) and generating at the output an error signal (ID) proportional to said error; and second subtracting means (97, 100, 104) connected at the input to said first subtracting means and to said generating means, and generating at the output said first operating signal (IC) as the difference between said second operating signal and said error signal.

2. A memory as claimed in Claim 1, **characterized in that** said connection means (72-106) comprises current mirror means.

3. A memory as claimed in Claim 1 or 2, **characterized by** a first (79, 80) and a second (84, 86) current mirror circuit; said first current mirror circuit having a control input connected to said reference cell, and an output; and said second current mirror circuit comprising a control element (84) connected to said output of said first current mirror circuit (79, 80), and a mirroring element (86) connected to said reference branches (41).

4. A memory as claimed in Claim 3, **characterized in that** said first current mirror circuit (79, 80) comprises a first (79) and a second (80) transistor, said first transistor (79) being diode-connected, being interposed between a first reference potential line (42) and said reference cell (60), and having a control terminal, and said second transistor (80) being connected between said first reference potential line (42) and said second current mirror circuit (84, 86), and having a control terminal connected to said control terminal of said first transistor; **in that** said control element comprises a diode-connected third transistor (84) interposed between a second reference potential line and said second transistor, and having a control terminal; and **in that** said mirroring element comprises a fourth transistor (86) having a first terminal connected to said second reference potential line, a second terminal connected to said reference branches (41), and a control terminal connected to said control terminal of said third transistor.

5. A memory as claimed in Claim 4, **characterized in that** said generating means comprise said second current mirror circuit (84, 86), said first subtracting means comprises a fifth transistor (81) current-mirror-connected to said first transistor (79) and interposed between said first reference potential line (42) and said fourth transistor (86); and a sixth transistor (93) connected between said first reference potential line and said fourth transistor (86); a seventh transistor (94) being current-mirror-connected to said sixth transistor (93); an eighth transistor (96) being interposed between said seventh transistor (94) and said second reference potential line; wherein said second subtracting means conprise a ninth transistor (97) current-mirror-connected to said eighth transistor (96); a tenth transistor (89) being current-mirror-connected to said third transistor (84); an eleventh transistor (91) connected between said first reference potential line and said tenth transistor (89); and a twelfth transistor (104) current-mirror-connected to said eleventh transistor (91) and interposed between said first reference potential line and said ninth transistor (97); a thirteenth transistor (106) being connected between said twelfth transistor (104) and said second reference potential line; and a plurality of fourteenth transistors (107) being current-mirror-connected to said thirteenth transistor (106) and each connected to a respective reference branch (41).

6. A memory as claimed in Claim 5, **characterized in that** said first (79), second (80), fifth (81), sixth (93), seventh (94), eleventh (91) and twelfth (104) transistors are PMOS transistors; and **in that** said third (84), fourth (86), eighth (96), ninth (97), tenth (89), thirteenth (106) and fourteenth (107) transistors are native NMOS transistors.

7. A memory as claimed in any one of the foregoing Claims, **characterized by** a reference memory array (71) separated from said data memory array (2); and in that said reference memory cell (60) forms part of said reference memory array.

## Patentansprüche

1. Nichtflüchtiger Speicher (35), welcher aufweist: Ein Datenspeicherfeld (2), welches Speicherzellen (5) beinhaltet; eine Leseschaltung (40), welche eine Vielzahl von Abtast- bzw. Leseverstärkern (10) aufweist, wobei jeder mit einem jeweiligen Feldzweig bzw. -abzweigung (17) zur Verbindung mit den Speicherzellen verbunden ist; und eine Referenzerzeugungsschaltung (70), welche eine Referenzzelle (60) aufweist, welche außerhalb des Datenspeicherfeldes (2) zur Erzeugung eines Referenzsignals (IR) angeordnet ist, wobei die Referenzerzeugungsschaltung (70) eine Vielzahl von Referenzzweigen (41), welche mit einem jeweiligen Leseverstärker (10) verbunden sind und welche elektronische Komponenten beinhaltet, und eine Verbindungsvorrichtung (72-106) aufweist, welche zwischen der Referenzzelle (60) und den Referenzzweigen (41) angeordnet ist, um die Referenzzweige mit einem ersten Betriebssignal (I2, IC). zu versorgen, welches mit dem Referenzsignal (IR) korreliert ist,
**dadurch gekennzeichnet, dass** die Verbindungsvorrichtung aufweist: Eine Erzeugungsvorrichtung (84, 86), welche an dem Eingang mit der Referenzzelle verbunden ist und welche am Ausgang ein zweites Betriebssignal (IM) erzeugt, welches mit dem Referenzsignal (IR) korreliert und welches einen ersten Fehler bietet; eine erste Subtrahiervorrichtung (81, 92, 93), welche an den Eingang mit der Referenzzelle (60) und der ersten Erzeugungsvorrichtung (84, 86) verbunden ist, und welche am Ausgang ein Fehlersignal (ID) erzeugt, proportional zu dem Fehler; und eine zweite Subtrahiervorrichtung (97, 100, 104), welche an dem Eingang mit der ersten Subtrahiervorrichtung und der Erzeugungsvorrichtung verbunden ist, und welche am Ausgang das erste Betriebssignal (IC) als die Differenz zwischen dem zweiten Betriebssignal und dem Fehlersignal erzeugt.

2. Speicher nach Anspruch 1, **dadurch gekennzeichnet, dass** die Verbindungsvorrichtung (72-106) eine Stromspiegelvorrichtung aufweist.

3. Speicher nach Anspruch 1 oder 2, **gekennzeichnet durch** eine erste (79, 80) und eine zweite (84, 86) Stromspiegelschaltung; wobei die erste Stromspiegelschaltung einen Steuereingang, der mit der Referenzzelle verbunden ist, und einen Ausgang besitzt; und wobei die zweite Stromspiegelschaltung ein Steuerelement (84), welches mit dem Ausgang der ersten Stromspiegelschaltung (79, 80) verbunden ist, und ein Spiegelelement (86) aufweist, welches mit den ersten Referenzzweigen (41) verbunden ist.

4. Speicher nach Anspruch 3, **dadurch gekennzeichnet, dass** die erste Stromspiegelschaltung (79, 80) aufweist: Einen ersten (79) und einen zweiten (80) Transistor, wobei der erste Transistor (79) Dioden-angeschlossen ist, wobei er zwischen einer ersten Referenzpotenzialleitung (42) und der Referenzzelle (60) angeordnet ist, und wobei er einen Steueranschluss besitzt, und wobei der zweite Transistor (80) zwischen der ersten Referenzpotenzialleitung (42) und der zweiten Stromspiegelschaltung (84, 86) angeschlossen ist, und wobei er einen Steueranschluss besitzt, welcher mit dem Steueranschluss des ersten Transistors verbunden ist; dass das Steuerelement aufweist: Einen Diodenangeschlossenen dritten Transistor (84), welcher zwischen einer zweiten Referenzpotenzialleitung und dem zweiten Transistor angeordnet ist und einen Steueranschluss besitzt; und dass das Spiegelelement einen vierten Transistor (86) aufweist, dessen erster Anschluss mit der zweiten Referenzpotenzialleitung verbunden ist, dessen zweiter Anschluss mit den Referenzzweigen (41) verbunden ist und dessen Steueranschluss mit dem Steueranschluss des dritten Transistors verbunden ist.

5. Speicher nach Anspruch 4, **dadurch gekennzeichnet, dass** die Erzeugungsvorrichtung die zweite Stromspiegelschaltung (84, 86) aufweist, die erste Subtrahiervorrichtung aufweist: Einen fünften Transistor (81), welcher Stromspiegel-angeschlossen mit dem ersten Transistor (79) ist und zwischen der ersten Referenzpotenzialleitung (42) und dem vierten Transistor (86) angeordnet ist; und einen sechsten Transistor (93), welcher zwischen der ersten Referenzpotenzialleitung und dem vierten Transistor (86) angeschlossen ist; einen siebten Transistor (94), welcher Stromspiegel-angeschlossen an dem sechsten Transistor (93) ist; einen achten Transistor (96), welcher zwischen dem siebten Transistor (94) und der zweiten Referenzpotenzialleitung angeordnet ist; wobei die zweite Subtrahiervorrichtung einen neunten Transistor (97) aufweist, welcher Stromspiegel-angeschlossen an dem achten Transistor (96) ist; einen zehnten Transistor (89), welcher Stromspiegel-angeschlossen mit dem dritten Transistor (84) ist; einen elften Transistor (91), welcher zwischen der ersten Referenzpotenzialleitung und dem zehnten Transistor (89) angeschlossen ist; und einen zwölften Transistor (104), welcher mit dem elften Transistor (91) Stromspiegel-angeschlossen ist und zwischen der ersten Referenzpotenzialleitung und dem neunten Transistor (97) angeordnet ist; einen dreizehnten Transistor (106), welcher zwischen dem zwölften Transistor (104) und der zweiten Referenzpotenzialleitung angeschlossen ist; und eine Vielzahl von vierzehnten Transistoren (107), welche mit dem dreizehnten Transistor (106) Stromspiegel-angeschlossen sind und wobei jeder mit einem jeweiligen Referenzzweig (41) verbunden ist.

6. Speicher nach Anspruch 5, **dadurch gekennzeichnet, dass** die ersten (79), zweiten (80), fünften (81), sechsten (93), siebten (94), elften (91) und zwölften (104) Transistoren PMOS-Transistoren sind; und dadurch, dass die dritten (84), vierten (86), achten (96),. neunten (97), zehnten (89), dreizehnten (106) und vierzehnten (107). Transistoren ursprüngliche bzw. native NMOS-Transistoren sind.

7. Speicher nach einem der vorausgehenden Ansprüche, **gekennzeichnet durch** ein Referenzspeicherfeld (71), welches von dem Datenspeicherfeld (2) getrennt ist; und **dadurch**, dass die Referenzspeicherzelle (60) einen Teil des Referenzspeicherfeldes bildet.

## Revendications

1. Mémoire non-volatile (35) comportant une matrice de mémoire de données (2) incluant des cellules de mémoire (5), un circuit de lecture (40) comportant une pluralité d'amplificateurs de lecture (10), chacun étant connecté à une branche respective de la matrice (17) en vue d'une connexion auxdites cellules de mémoire, et un circuit de génération de référence (70) comportant une cellule de référence (60) agencée à l'extérieur de ladite matrice de mémoire de données (2) destiné à générer un signal de référence (IR), ledit circuit de génération de référence (70) comportant une pluralité de branches de référence (41), chacune étant connectée à un amplificateur de lecture (10) respectif et incluant des composants électroniques, et des moyens de connexion (72-106) intercalés entre ladite cellule de référence (60) et lesdites branches de référence (41) destinés à délivrer un premier signal de fonctionnement (12, IC) mis en corrélation avec ledit signal de référence (IR) auxdites branches de référence,
**caractérisée en ce que** lesdits moyens de connexion comportent des moyens de génération (84, 86) reliés à l'entrée de ladite cellule de référence et générant à la sortie un second signal de fonctionnement (IM) mis en corrélation avec ledit signal de référence (IR) et présentant une erreur, des premiers moyens de soustraction (81, 92, 93) reliés à l'entrée de ladite cellule de référence (60) et desdits premiers moyens de génération (84, 86) et générant à la sortie un signal d'erreur (ID) proportionnel à ladite erreur, et des seconds moyens de soustraction (97, 100, 104) reliés à l'entrée desdits premiers moyens de soustraction et desdits moyens de génération, et générant à la sortie ledit premier signal de fonctionnement (IC) en tant que différence entre ledit second signal de fonctionnement et ledit signal d'erreur.

2. Mémoire selon la revendication 1, **caractérisée en ce que** lesdits moyens de connexion (72-106) comportent des moyens miroir de courant.

3. Mémoire selon la revendication 1 ou 2, **caractérisée par** un premier circuit miroir de courant (79, 80) et un second circuit miroir de courant (84, 86), ledit premier circuit miroir de courant ayant une entrée de commande reliée à ladite cellule de référence, et une sortie, et ledit second circuit miroir de courant comportant un élément de commande (84) relié à ladite sortie dudit premier circuit miroir de courant (79, 80), et un élément miroir (86) relié auxdites branches de référence (41).

4. Mémoire selon la revendication 3, **caractérisée en ce que** ledit premier circuit miroir de courant (79, 80) comporte un premier transistor (79) et un deuxième transistor (80), ledit premier transistor (79) qui est monté en diode, étant intercalé entre une première ligné de potentiel de référence (42) et ladite cellule de référence (60), et ayant une borne de commande, et ledit deuxième transistor (80) étant relié entre ladite première ligne de potentiel de référence (42) et ledit second circuit miroir de courant (84, 86), et ayant une borne de commande reliée à ladite borne de commande dudit premier transistor, et **en ce que** ledit élément de commande comporte un troisième transistor monté en diode (84) intercalé entre une seconde ligne de potentiel de référence et ledit deuxième transistor, et ayant une borne de commande, et **en ce que** ledit élément miroir comporte un quatrième transistor (86) ayant une première borne reliée à ladite seconde ligne de potentiel de référence, une seconde borne reliée auxdites branches de référence (41), et une borne de commande reliée à ladite borne de commande dudit troisième transistor.

5. Mémoire selon la revendication 4, **caractérisée en ce que** lesdits moyens de génération comportent ledit second circuit miroir de courant (84, 86), lesdits premiers moyens de soustraction comportent un cinquième transistor (81) monté en miroir de courant avec ledit premier transistor (79) et intercalé entre ladite première ligne de potentiel de référence (42) et ledit quatrième transistor (86), et un sixième transistor (93) relié entre ladite première ligne de potentiel de référence et ledit quatrième transistor (86), un septième transistor (94) monté en miroir de courant avec ledit sixième transistor (93), un huitième transistor (96) intercalé entre ledit septième transistor (94) et ladite seconde ligne de potentiel de référence, lesdits seconds moyens de soustraction comportant un neuvième transistor (97) monté en miroir de courant avec ledit huitième transistor (96), un dixième transistor (89) monté en miroir de courant avec ledit troisième transistor (84), un onzième transistor (91) relié entre ladite première ligne de potentiel de référence et ledit dixième transistor (89), et un douzième transistor (104) monté en miroir de courant avec ledit onzième transistor (91) et intercalé entre ladite première ligne de potentiel de référence et ledit neuvième transistor (97), un treizième transistor (106) relié entre ledit douzième transistor (104) et ladite seconde ligne de potentiel de référence, et une pluralité de quatorzièmes transistors (107) montés en miroir de courant avec ledit treizième transistor (106) et chacun étant relié à une branche de référence (41) respective.

6. Mémoire selon la revendication 5, **caractérisée en ce que** lesdits premier (79), deuxième (80), cinquième (81), sixième (93), septième (94), onzième (91) et douzième (104) transistors sont des transistors PMOS (MOS à canal P), et **en ce que** lesdits troisième (84), quatrième (86), huitième (96), neuvième (97), dixième (89), treizième (106) et quatorzième (107) transistors sont des transistors NMOS (MOS à canal P) natifs.

7. Mémoire selon l'une quelconque des revendications précédentes, **caractérisée par** une matrice de mémoire de référence (71) séparée de ladite matrice de mémoire de données (2), et en ce que ladite cellule de mémoire de référence (60) fait partie de ladite matrice de mémoire de référence.
